# EUROPEAN PATENT APPLICATION

(11) **EP 4 386 408 A1**
(43) Date of publication of application: **19.06.2024**
(21) Application number: 22315326.3
(22) Date of filing: 13.12.2022
(51) Int. Cl.: G01R 33/00, G01R 33/09, G01R 15/20

(54) **MAGNETIC SENSOR DEVICE FOR SENSING A MAGNETIC FIELD AND HAVING LOW SENSITIVITY TO INHOMOGENEITIES IN THE MAGNETIC FIELD**

(71) Applicant: Allegro MicroSystems, LLC, Manchester, NH 03103 (US)
(72) Inventor: Mouchel, Myckael, 38000 Grenoble (FR); Alvarez-Hérault, Jérémy, 38134 Saint-Joseph de Rivière (FR); Lombard, Lucien, 38640 Claix (FR)
(74) Representative: South, Nicholas Geoffrey

(57) **Abstract**

Magnetic sensor device (100) for sensing an external magnetic field (60), the magnetic sensor device (100) comprising a plurality of branches (110-140) electrically connected in a bridge circuit. At least one branch comprises a magnetic sensitive branch configured to sense the external magnetic field. Each branch (110-140) comprises a plurality of sub-branches (111-141) electrically connected with each other. The sub-branches (111-141) in each branch (110-140) are arranged within a sensing area (160). The sub-branches (111-141) in a branch (110-140) have a centroid (C160) that is common to the centroid of the sub-branches (111-141) in another branches (110-140). The magnetic sensor device provides a read signal that is less sensitive to inhomogeneities in the external magnetic field. Also disclosed is a magnetic sensor system comprising at least one magnetic sensor device.

## Description

### Technical domain

The present invention concerns a magnetic sensor device for sensing an external magnetic field that provides a read signal that is less sensitive to inhomogeneities in the external magnetic field. The present invention further concerns a magnetic sensor system comprising at least one magnetic sensor device.

### Related art

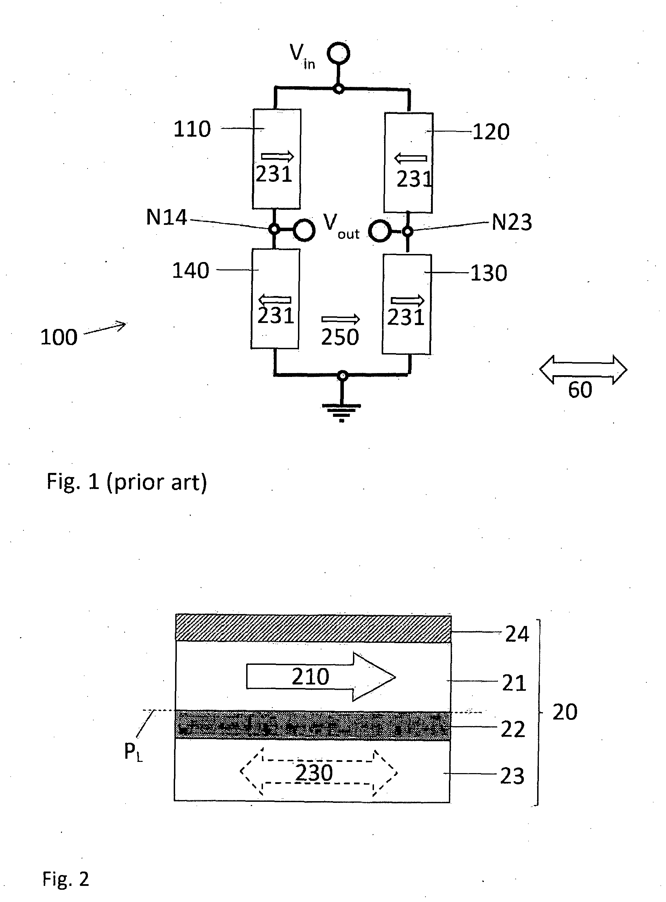

A magnetic sensor device 100 for sensing an external magnetic field 60 is shown in Fig. 1. The magnetic sensor device 100 can comprise a plurality of branches 110-140 electrically connected in a full-bridge circuit 100, such as a Wheatstone bridge circuit. For example, the full-bridge circuit 100 comprises a first branch 110, a second branch 120, a third branch 130, and a fourth branch 140. Each branch 110-140 can comprise one or a plurality of magnetoresistive sensor elements 20. In Fig. 1, the first node at which the first and fourth branches 110, 140 are connected is indicated by the symbol N14 and the second node at which the second and third branches 120, 130 are connected is indicated by the symbol N23. A read signal Vₒᵤₜ can be measured between the first node N14 and the second node N23. The read signal Vₒᵤₜ is a fraction of the input voltage Vᵢₙ of the Wheatstone bridge circuit.

As illustrated in Fig. 2, each magnetoresistive sensor element 20 can comprise a tunnel barrier layer 22 sandwiched between a ferromagnetic reference layer 23 having a pinned reference magnetization 231, and a ferromagnetic sense layer 21 having a sense magnetization 211 that can be freely oriented in the external magnetic field. The magnetic sensor device senses the magnitude and/or orientation the external magnetic field 60 by measuring the conductance (or resistance) of the magnetoresistive sensor elements 20 that depends on the orientation of the sense magnetization 211 relative to the orientation of the reference magnetization 231. For example, when the sense magnetization 211 is parallel to the reference magnetization 231 the magnetoresistive sensor elements 20 has a low resistance. When the sense magnetization 211 is antiparallel to the reference magnetization 231 the magnetoresistive sensor elements 20 has a high resistance.

A sensing axis 250 of the Wheatstone bridge circuit coincides with the direction of the pinned reference magnetization 231 of the one or plurality of magnetoresistive sensor elements 20 in each branch 110-140, as represented in Fig. 1. When the external magnetic field 60 is collinear to the sensing axis 250 the Wheatstone bridge circuit provides a maximal Vᵢₙ/Vₒᵤₜ value for positive amplitude of the external magnetic field 60 and minimal Vᵢₙ/Vₒᵤₜ value for negative amplitude of the external magnetic field 60.

In many practical situations, the external magnetic field is not homogeneous across the surface area of the magnetic sensor device. This can be the case when the size magnetic sensor device is larger than that of a local external magnetic field being sensed.

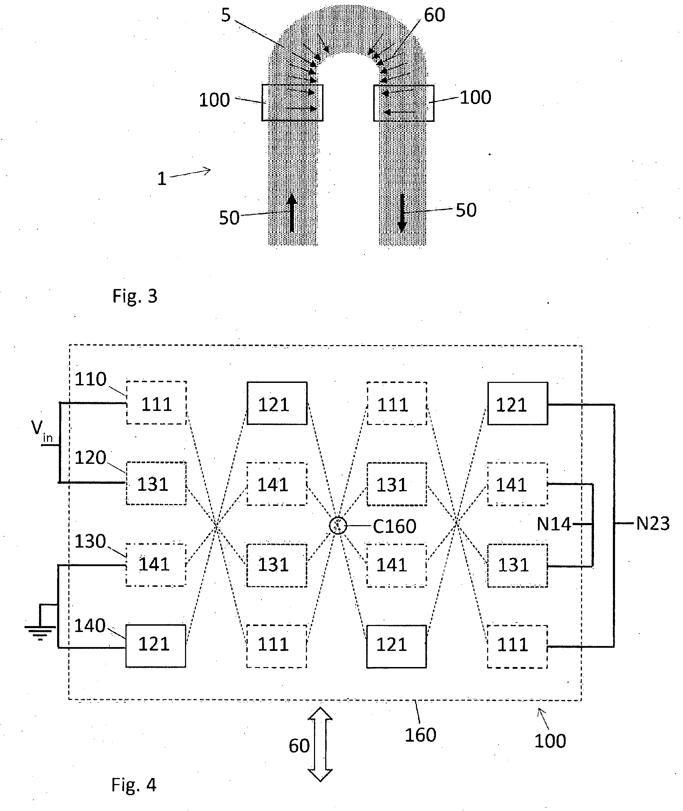

Fig. 3 shows an example of a magnetic sensor system 1 comprising a current sensor. The current sensor 1 comprises a U-shaped current line 5 and two magnetic sensor devices 100 comprising a full-bridge circuit. The two magnetic sensor devices 100 are in the vicinity of the curved portion of the current line 5. When a current 50 is passed in the current line 5 the magnetic field 60 generated by the current 50 and being measured by the magnetic sensor devices 100 is not homogeneous at the scale of the magnetic sensor device 100.

In other words, in the case of the magnetic sensor device 100 comprising a plurality of branches 110-140 electrically connected in a full-bridge circuit 100, such as the Wheatstone bridge circuit shown in Fig.1, the magnetic field 60 sensed by one of the branches 110-140 will differ from the magnetic field 60 sensed by another branch 110-140. This can induce errors on sensitivity, linearity or offset in the response of the magnetic sensor device 100. For the case of the magnetic sensor system 1 shown in Fig. 3, the differences in the external magnetic field 60 seen by a given branch 110-140 can be typically above 8% along its sensing axis 250.

### Summary

The present disclosure concerns a magnetic sensor device for sensing an external magnetic field. The magnetic sensor device comprises a plurality of branches electrically connected in a bridge circuit. At least one branch comprises a magnetic sensitive branch configured to sense the external magnetic field. Each branch comprises a plurality of sub-branches electrically connected with each other. The sub-branches in each branch are arranged within a sensing area. In the sensing area 160, the sub-branches in a branch have a centroid that is common to the centroid of the sub-branches in another branches.

The present disclosure further concerns a magnetic sensor system comprising at least one magnetic sensor device.

The arrangement of the sub-branches across the sensing area allows for averaging the external magnetic field seen by the sub-branches such that each of the branches sees substantially the same averaged external magnetic field. The magnetic sensor device provides a read signal that is less sensitive to inhomogeneities in the external magnetic field. The bridge is well equilibrated and can be used to sense the average external magnetic field.

### Short description of the drawings

Exemplar embodiments of the invention are disclosed in the description and illustrated by the drawings in which:
Fig. 1 shows a magnetic sensor device for sensing an external magnetic field comprising a plurality of branches electrically connected in a full-bridge circuit;
Fig. 2 illustrates a magnetoresistive sensor element;
Fig. 3 illustrates a current sensor comprising a U-shaped current line and two magnetic sensor devices;
Fig. 4 schematically represents a magnetic sensor device, according to an embodiment; and
Fig. 5 schematically represents the magnetic sensor device, according to another embodiment.

### Examples of embodiments

Fig. 4 schematically represents a layout of the magnetic sensor device 100 for sensing an external magnetic field, the magnetic sensor device comprising a plurality of branches 110-140 electrically connected in a Wheatstone bridge circuit. Each branch 110-140 comprises a plurality of sub-branches 111-141 electrically connected with each other. The sub-branches 111-141 can be electrically connected in series or in parallel, or partly in series and in parallel. At least one branch 110-140 comprises a magnetic sensitive branch.

In an embodiment, the sub-branches 111-141 are distributed across a sensing area 160 of the magnetic sensor device. The sub-branches 111-141 in a branch 110-140 have a centroid C160 that is the same as the centroid C160 of the sub-branches 111-141 in another branch 110-140 (common-centroid layout).

In the configuration shown in Fig. 4, the magnetic sensor device 100 comprises four branches, namely a first branch 110, a second branch 120, a third branch 130, and a fourth branch 140. Each branch 110-140 comprises four sub-branches 111-144. In particular, the first branch 110 comprises four first sub-branches 111, the second branch 120 comprises four second sub-branches 121, the third branch 130 comprises four third sub-branches 131, and the fourth branch 140 comprises four fourth sub-branches 141. The sub-branches 111-144 are electrically connected in series, as represented by the dotted lines in Fig. 4. Each branch 110-140 comprises a magnetic sensitive branch. Here, each sub-branch 111-141 comprises at least one magnetoresistive sensor element 20.

The four branches 110-140 are electrically connected in a full-bridge circuit 100, such as a Wheatstone bridge circuit, as represented by the plain lines in Fig. 4. The first node at which the first and fourth branches 110, 140 are connected is indicated by the symbol N14 and the second node at which the second and third branches 1210, 130 are connected is indicated by the symbol N23. A read signal Vₒᵤₜ can be measured between the first node N14 and the second node N23. The value of the read signal Vₒᵤₜ depends on the ratio of the resistances of each magnetoresistive sensor element 20 comprised in each sub-branches 111-141.

In the configuration of the magnetic sensor device shown in Fig. 4, the sub-branches 111-141 in a branch 110-140 have a centroid C160 that is the same as the centroid C160 of the sub-branches 111-141 in another sensing branch 110-140. The common centroid C160, also known as geometric center, is the arithmetic mean position of all the branches 110-140 in the sensing area 160. In this configuration, the Wheatstone bridge circuit is well equilibrated and can be used to sense the average external magnetic field 60.

The sub-branches 111-141 in each branch 110-140 can be arranged symmetrically around the common centroid C160. Alternatively, the sub-branches 111-141 in each branch 110-140 can be arranged asymmetrically around the common centroid C160.

The arrangement of the sub-branches 111-141 across the sensing area 160 allows for averaging the external magnetic field 60 seen by the sub-branches 111-141 such that each of the branches 110-140 sees substantially the same averaged external magnetic field 60.

The equivalent electrical circuit of the magnetic sensor device 100 of Fig. 4 is the same as the magnetic sensor device of Fig. 1 since the branches 110-140 are electrically connected in a full-bridge circuit. However, the layout of each branch 110-140 is distributed across the sensing area 160, by the arrangement of the sub-branches 111-141 (the branches 110-140 occupy different zones of the sensing area 160). A good averaging of the external magnetic field 60 on each branch 110-140 can be obtained if the common centroid C160 of the branches 110-140 is at the center of the sensing area 160.

Although in the example of Fig. 4 each branch 110-140 comprises four sub-branches 111-141, the branch 110-140 could comprise at least two sub-branches 111-141 (claim 1). Preferably, each branch 110-140 comprises at least four sub-branches 111-141, such that each of the branches 110-140 is exposed to the full range of non-uniformity of the external magnetic field 60 and can see substantially the same averaged external magnetic field 60. The number of sub-branches 111-141 can be odd or even.

The magnetic sensor device 100 represented in Fig. 4 can comprise two half-bridge circuits (one half-bridge circuit comprising the branches 110 and 140 and another half-bridge circuit comprising the branches 120 and 130), the two half-bridge circuits forming a full-bridge circuit. In such configuration, the centroid of each half-bridge should be common to the centroid of the full-bridge C160.

It should be noted that the branches 110-140 can also be electrically connected in other configurations than a Wheatstone or full-bridge circuit. For example, the branches 110-140 can be electrically connected in half-bridge circuit. In other word, the expression "bridge circuit" should be understood as meaning a full bridge circuit, a half-bridge circuit, or any other type of bridge circuit.

Moreover, the magnetic sensor device 100 can be configured such that not all the branches 110-140 comprise a magnetic sensitive branch configured to sense the external magnetic field. For example, one of the branches 110-140 can comprise one magnetic sensitive branch, for example comprising magnetoresistive sensor element 20, and the other branches 110-140 comprise at least a resistor element.

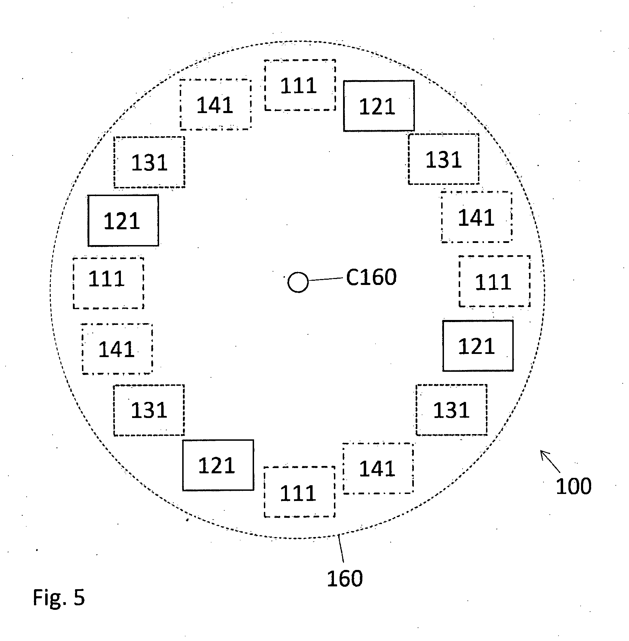

In the example of Fig. 4, the sub-branches 111-141 are arranged in a layout comprising an array of rows and columns. Other layout configurations are however possible. For example, the sub-branches 111-141 can be arranged in a star-shaped layout such as shown in Fig. 5, wherein each sub-branch 111-141 are arranged equidistant from the common centroid C160. The sub-branches 111-144 are electrically connected (not shown in Fig. 5). The four branches 110-140 are electrically connected in a full-bridge circuit 100, such as a Wheatstone bridge circuit.

Other configurations of the branch 110-140 and of the sub-branches 111-141 are possible, provided the sub-branches 111-141 in each branch 110-140 are arranged at equal distances from the common centroid C160. The centroid of one of the sub-branches 111-141 in a branch 110-140 should be the same as the centroid 160 of the sub-branches 111-141 in another branches 110-140.

In an embodiment, the sub-branches 111-141 in all the branches 110-140 are equidistant from the common centroid C160. Such arrangement allows for reducing the effect of high order inhomogeneity, for example quadratic order or more, of the external magnetic field 60 on the read Vₒᵤₜ signal of the magnetic sensor device 100. For example, in the magnetic sensor device 100 shown in Fig. 5, all sub-branches 111-141 are at the same distance to the common centroid 160.

The arrangement of the sub-branches 111-141 in each branch 110-140 in the magnetic sensor device 100 disclosed herein allows for reducing the differences in the external magnetic field 60 seen by a given branch 110-140. In the magnetic sensor device 100 configuration shown in Fig. 4, the differences in the external magnetic field 60 seen by a given branch 110-140 by about 0.3% along its sensing axis 250. More particularly, the magnetic sensor device 100 in the configuration shown in Fig. 4 can provide a read signal that is at least 30 times less sensitive to inhomogeneities in the external magnetic field 60.

Also disclosed is a magnetic sensor system 1 comprising at least one magnetic sensor device 100. An example of the magnetic sensor system 1 is shown in Fig. 3 wherein the magnetic sensor system 1 is a current sensor comprising a U-shaped current line 5 and two magnetic sensor devices 100. Each magnetic sensor device 100 can comprise a full-bridge circuit. When a current 50 is passed in the current line 5, the sub-branches 111-141 of each of the two magnetic sensor devices 100 that are in the vicinity of the curved portion of the current line 5 sees a averaged external magnetic field 60. The magnetic sensor system 1 thus provides a read signal that is less sensitive to inhomogeneities in the external magnetic field 60.

Moreover, the read signal of the magnetic sensor device 100 disclosed herein is not affected (or at least substantially less affected) by a misplacement of the magnetic sensor device 100 relative to the U-shaped current line 5. For example, the magnetic sensor devices in the magnetic sensor system 1 of Fig. 3 provides a read signal that is at least 30 times less , sensitive to inhomogeneities in the external magnetic field. Compared to a conventional magnetic sensor device, the magnetic sensor device 100 disclosed herein can have an increased die size and thus, provide the read signal with reduced noise.

### Reference numbers and symbols

- 1: magnetic sensor system
- 10: magnetoresistive sensor element
- 10, 20: branch
- 100: magnetic sensor device, full-bridge circuit
- 110, 120: branch
- 111, 121: sub-branch
- 130, 140: branch
- 131, 141: sub-branch
- 160: sensing area
- 20: magnetoresistive sensor element
- 21: reference layer
- 210: reference magnetization
- 22: tunnel barrier layer
- 23: sense layer
- 231: sense magnetization
- 250: sensing axis
- 5: current line
- 50: current
- 60: external magnetic field
- C160: common centroid
- N14: first node
- N23: second node
- Vᵢₙ: input voltage
- Vₒᵤₜ: read signal

## Claims

1. Magnetic sensor device (100) for sensing an external magnetic field (60), the magnetic sensor device (100) comprising a plurality of branches (110-140) electrically connected in a bridge circuit,
wherein at least one branch (110-140) comprises a magnetic sensitive branch configured to sense the external magnetic field (60);
wherein each branch (110-140) comprises a plurality of sub-branches (111-141) electrically connected with each other;
wherein the sub-branches (111-141) in each branch (110-140) are arranged within a sensing area (160); and
wherein the sub-branches (111-141) in a branch (110-140) have a centroid (C160) that is common to the centroid (C160) of the sub-branches (111-141) in another branch (110-140).

2. The magnetic sensor device according to claim 1,
wherein the sub-branches (111-141) in each branch (110-140) are arranged symmetrically around the common centroid (C160).

3. The magnetic sensor device according to claim 1 or 2,
wherein the sub-branches (111-141) in all the branches (110-140) are equidistant from the common centroid (C160).

4. The magnetic sensor device according to any one of claims 1 to 3,
wherein the sub-branches (111-141) are arranged symmetrically around the common centroid (C160).

5. The magnetic sensor device according to any one of claims 1 to 4,
wherein each sub-branches (111-141) in the at least one branch (110-140) comprises at least one magnetoresistive sensor element (20).

6. The magnetic sensor device according to any one of claims 1 to 5,
wherein each branch (110-140) comprises at least four sub-branches (111-141).

7. The magnetic sensor device according to claim 6,
wherein the sub-branches (111-141) are arranged in a layout comprising an array of rows and columns.

8. The magnetic sensor device according to any one of claims 1 to 7,
wherein each branch (110-140) comprises a magnetic sensitive branch.

9. The magnetic sensor device according to any one of claims 1 to 7,
comprise two half-bridge circuits forming a full-bridge circuit, wherein the centroid of each half-bridge is common to the centroid of the full-bridge (C160).

10. Magnetic sensor system (1) comprising at least one magnetic sensor device (100) according to any one of claims 1 to 9.

11. Magnetic sensor system (1)according to claim 10,
comprising a U-shaped current line (5) and two magnetic sensor devices (100)
